Europäisches Patentamt

European Patent Office

Office européen des brevets

(19)

(11) Veröffentlichungsnummer : **0 110 218 B1**

(12) **EUROPÄISCHE PATENTSCHRIFT**

(45) Veröffentlichungstag der Patentschrift : 21.01.87

(21) Anmeldenummer : 83111268.5

(22) Anmeldetag : 11.11.83

(51) Int. Cl.⁴ : **F 21 Q 3/00**

(54) **Signallampe mit Leuchtdiode.**

(30) Priorität : 19.11.82 CH 6737/82

(43) Veröffentlichungstag der Anmeldung :
13.06.84 Patentblatt 84/24

(45) Bekanntmachung des Hinweises auf die Patenterteilung : 21.01.87 Patentblatt 87/04

(84) Benannte Vertragsstaaten :
**AT BE CH DE FR GB IT LI LU NL SE**

(56) Entgegenhaltungen :
**CH-A- 400 845**
**CH-A- 462 908**
**DE-A- 1 465 311**
**DE-A- 1 589 297**
**DE-A- 2 951 081**

(73) Patentinhaber : **W. Schmid AG**
**Dorfstrasse 23**
**CH-5442 Fislisbach (CH)**

(72) Erfinder : **Schmid, Willi**
**Dorfstrasse 23**
**CH-5442 Fislisbach (CH)**

(74) Vertreter : **Fillinger, Peter, Dr.**
**Rütistrasse 1a**
**CH-5400 Baden (CH)**

**Beschreibung**

Die vorliegende Erfindung bezieht sich auf eine Signallampe mit Leuchtdiode nach dem Oberbegriff des Patentanspruches 1.

Eine solche Signallampe ist beispielsweise in der DE-A-29 51 081 beschrieben. Diese bekannte Signallampe hat den Nachteil, dass ihr Zusammenbau, einschliesslich dem Einsetzen der Leuchtdioden und ihrem Verlöten mit der die Anschlussleitungen aufweisenden Platte, erst nach dem Einbau des Lampengehäuses in die Frontwand einer Schalttafel oder eines Apparategehäuses erfolgen kann. Dabei haben einzelne Handgriffe von der Frontplattenvorderseite und andere von deder Rückseite her zu erfolgen, wodurch ihr Zusammenbau und ihr Einbau in eine Frontwand äussert zeitbeanspruchend ist.

Die gattungsfremde DE-A-14 65 311 offenbart eine Glimmlampenfassung, die dazu bestimmt ist, bei Lichtschaltern von Hausinstallationen zwischen der Abdeckplatte und dem Schaltersockel angebracht zu werden. Sie kann nicht von vorne in die Durchbrechung einer Frontplatte gesteckt werden.

In der ebenfalls gattungsfremden DE-A-15 89-297 wird eine Glimmlampenfassung beschrieben, bei der die Glimmlampe auf einem Sockel angeordnet und mit dem Sockel in ein ihn allseits umschliessendes Gehäuse geschoben ist. Dieses Gehäuse weist indessen keine Mittel auf, um in eine Durchbrechung einer Frontplatte von vorne eingeschoben und darin befestigt zu werden.

Die in der CH-A-400 845 beschriebene Signallampe weist eine zur Lampenöffnung rechtwinklig orientierte Leiterplatte auf, was eine in vielen Anwendungsfällen zu grosse Bautiefe bewirkt, wobei zudem die Leuchtröhre nur in zur Ebene der Oeffnung paralleler Richtung und nicht senkrecht dazu ausgewechselt werden kann.

Die vorliegende Erfindung stellt sich die Aufgabe, eine Vorrichtung der eingangs erwähnten Art zu verbessern, so, dass sie in zusammengebautem Zustand und unter Wahrung einer geringen Einbautiefe von vorne in die Durchbrechung einer Frontplatte einsetzbar ist.

Erfindungsgemäss wird diese Aufgabe gelöst durch die kennzeichnenden Merkmale des Anspruches 1.

Weiter können defekte Leuchtdioden sowohl von der Vorderseite der Frontplatte als auch von deren Rückseite her ausgewechselt werden.

Eine besonders flache Bauweise wird dadurch erreicht, dass der der Leuchtdiode zugeordnete Vorwiderstand mit seiner Längsachse parallel zur Leiterplatte angeordnet ist.

Zur Erleicherung der Verdrahtung der Signallampe wird vorgeschlagen, die Anschlussklemmen auf der der Leuchtdiode abgewandten Seite der Leiterplatte, d. h., auf der gut einsehbaren und leicht zugänglichen Rückseite anzuordnen.

Die frontseitige Montage wird dadurch erleichtert, dass am Lampengehäuse seitlich Rastverbindungsmittel vorhanden sind, die mit der Schalttafel seitlich verrasten.

Ein rascher und einfacher Zusammenbau wird dadurch erreicht, dass die Leiterplatte durch Rastverbindungsmittel mit dem Lampengehäuse verbunden ist.

Um das Innere der Signallampe weitgehend gegen Flugstaub zu schützen ist vorgesehen, dass der lichtdurchlässige Mantel der achsial zur Oeffnung ausgerichteten Leuchtdiode jene mindestens näherungsweise überdeckt. Anhand der beiden liegenden schematischen Zeichnungen wird die Erfindung beispielsweise erläutert. Es zeigen :

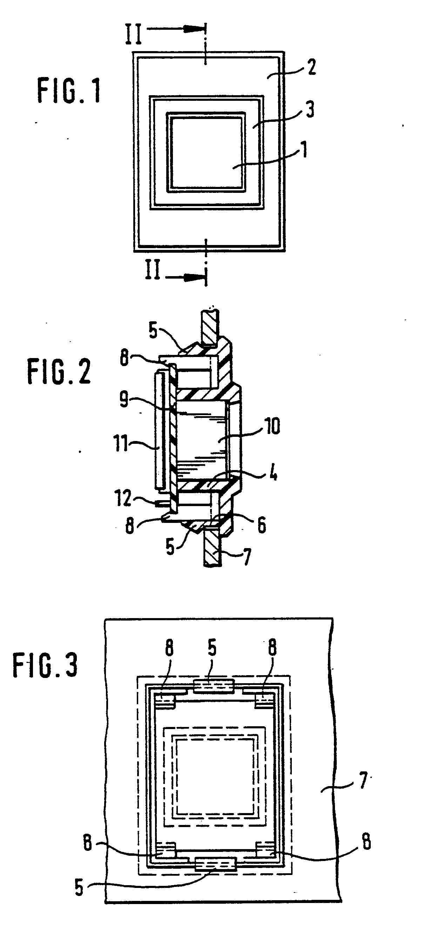

Figur 1 eine Frontansicht einer Signallampe,

Figur 2 einen Schnitt längs der Linie II-II in Fig. 1 und

Figur 3 eine rückseitige Ansicht der Signallampe nach den Fig. 1 und 2 welche in eine Schalttafel eingesetzt ist.

Das Lampengehäuse weist frontseitig einen eine Oeffnung 1 umgebenden Rahmen 2 auf, der mit einem an die Oeffnung 1 anschliessenden flachen Wulst 3 versehen ist. An der Rahmenrückseite ist das Lampengehäuse mit einer die Oeffnung 1 umgebenden Zentrierrippe 4 versehen, die gleichzeitig als Distanzelement für eine Leiterplatte 9 wirkt. An zwei gegenüberliegenden Seiten des Rahmens 2 sind nach aussen weisende Rastfedern 5 vorhanden, die der Befestigung der Signallampe in der Durchbrechung 6 einer Schalttafel 7 dienen. An vier weiteren Rastfedern 8 des Schaltergehäuses ist die die Leuchtdiode 10 tragende Leiterplatte 9 gehalten an der zudem ein Vorwiderstand 11 befestigt ist. Die Leuchtdiode 10 wird durch die Zentrierrippe 4 achsial auf die Oeffnung 1 ausgerichtet und im notwendigen Abstand zur Frontfläche des Lampengehäuses gehalten, da die Leiterplatte 9 rückseitig gegen die Zentrierrippe 4 anliegt, während sie in vier Rastfedern 8 gehalten ist. Der Vorwiderstand 11 ist mit seiner Längsachse parallel zur Leiterplatte 9 ausgerichtet. Er kann auf der gleichen Leiterplattenseite wie die Leuchtdiode 10 oder ihr gegenüberliegend angeordnet sein. In beiden Fällen bleibt eine äusserst flache Bauweise der Signallampe gewährleistet.

Auf der der Leuchtdiode 10 abgewandten Seite der Leiterplatte 9 sind zudem deren Anschlussklemmen 12 vorgesehen, welche dadurch für die Verdrahtung gut erkennbar und leicht zugänglich sind.

Die Leiterplatte 9 kann eine Printplatte oder eine gestanzte oder gesprizte Kunststoffplatte sein auf der gestanzte Leiter oder Drähte als Verbindung eingelegt und verlötet oder verschweisst werden. Ist die Leiterplatte 9 eine Kunststoffplatte, so können auch Leiterbahnen aufgedruckt oder metallbeschichtet sein.

Der lichtdurchlässige Mantel der Leuchtdiode 10 hat vorzugsweise eine quaderförmige und zylindrische Aussenform und ist auf die Oeffnung

im Lampengehäuse abgestimmt. Hat das Lampengehäuse mehrere Oeffnungen 1, denen je eine Leuchtdiode zugeordnet ist, so sind diese Leuchtdioden vorzugsweise auf einer gemeinsame Platte 9 angeordnet.

## Patentansprüche

1. Signallampe mit mindestens einer Oeffnung (1) in einem Lampengehäuse, wobei durch jede Oeffnung (1) je eine Leuchtdiode (10) sichtbar und die Leuchtdiode (10) an einer zur Oeffnung (10) parallelen, die Anschlussleitungen aufweisenden Leiterplatte (9) angeschlossen ist, dadurch gekennzeichnet, dass die Leiterplatte (9) lösbar am Lampengehäuse (2, 3, 4) befestigt ist, dass das Lampengehäuse (2, 3, 4) einen die Oeffnung (1) umgebenden Frontrahmen (2) aufweist, dessen Umfangskontur grösser als jene der Leiterplatte (9) ist, und dass auf der Rückseite des Frontrahmens (2) gegen die Platte (9) orientierte Zentrierrippen (4) angeordnet sind, welche die Leuchtdiode (10) aufnehmen und bezüglich der Oeffnung (1) zentrieren.

2. Signallampe nach Anspruch 1, dadurch gekennzeichnet, dass der der Leuchtdiode (10) zugeordnete Vorwiderstand (11) mit seiner Längsachse parallel zur Leiterplatte (9) angeordnet ist.

3. Signallampe nach Anspruch 1, dadurch gekennzeichnet, dass die Anschlussklemmen (12) auf der der Leuchtdiode (10) abgewandten Seite der Leiterplatte (9) angeordnet sind.

4. Signallampe nach Anspruch 1, dadurch gekennzeichnet, dass seitlich wirkende Rastverbindungsmittel (5) vorhanden sind.

5. Signallampe nach Anspruch 1, dadurch gekennzeichnet, dass die Leiterplatte (9) durch Rastverbinddungsmittel (8) mit dem Lampengehäuse verbunden ist.

6. Signallampe nach Anspruch 1, dadurch gekennzeichnet, dass der lichtdurchlässige Mantel der achsial zu Oeffnung (1) ausgerichteten Leuchtdiode (10) jene mindestens näherungsweise überdeckt.

7. Signallampe nach einem der Ansprüche 1 bis 6, dadurch gekennzeichnet, dass die Leiterplatte (9) eine Printplatte ist.

8. Signallampe nach einem der Ansprüche 1 bis 6, dadurch gekennzeichnet, dass die Leiterplatte (9) eine Kunststoffplatte ist und darauf gestanzte Leiter oder Drähte als Verbindung eingelegt und verlötet oder verschweisst sind.

9. Signallampe nach einem der Ansprüche 1 bis 6, dadurch gekennzeichnet, dass die Leiterplatte (9) eine Kunststoffplatte ist, welche aufgedruckte oder durch Metallbeschichtung aufgebrachte Leiterbahnen aufweist.

10. Signallampe nach Anspruch 6, dadurch gekennzeichnet, dass der lichtdurchlässige Mantel der Dioden quader-oder zylinderförmig ist.

11. Signallampe nach Anspruch 1, dadurch gekennzeichnet, dass im Gehäuse mehrere Oeffnungen mit je einer zugeordneten Leuchtdiode vorhanden und die Leuchtdioden auf einer gemeinsamen Leiterplatte angeordnet sind und ein gemeinsamer Anschluss für die Leuchtdioden auf der gegenüberliegenden Plattenseite liegt.

## Claims

1. Signal lamp with at least one orifice (1) in a lamp housing, a luminous diode (10) being visible through each orifice (1) and the luminous diode (10) being connected to a circuit board (9) which is parallel to the orifice (10) and which has the connecting leads, characterized in that the circuit board (9) is fastened releasably to the lamp housing (2, 3, 4), in that the lamp housing (2, 3, 4) has a front frame (2) which surrounds the orifice (1) and the peripheral contour of which is larger than that of the circuit board (9), and in that arranged on the rear side of the front frame (2) are centering ribs (4) which are directed towards the board (9) and which receive the luminous diode (10) and centre it relative to the orifice (1).

2. Signal lamp according to Claim 1, characterized in that the dropping resistor (11) assigned to the luminous diode (10) is arranged with its longitudinal axis parallel to the circuit board (9).

3. Signal lamp according to Claim 1, characterized in that the connecting terminals (12) are arranged on the side of the circuit board (9) facing away from the luminous diode (10).

4. Signal lamp according to Claim 1, characterized in that laterally acting locking connection means (5) are provided.

5. Signal lamp according to Claim 1, characterized in that the circuit board (9) is connected to the lamp housing by locking connection means (8).

6. Signal lamp according to Claim 1, characterized in that the light-transmitting casing of the luminous diode (10) directed axially relative to the orifice (1) covers the latter at least approximately.

7. Signal lamp according to one of Claims 1 to 6, characterized in that the circuit board (9) is a printed board.

8. Signal lamp according to one of Claims 1 to 6, characterized in that the circuit board (9) is a plastic board, and stamped conductors or wires are inserted and soldered or welded on it as connection means.

9. Signal lamp according to one of Claims 1 to 6, characterized in that the circuit board (9) is a plastic board which has conductor tracks printed on or applied by means of a metal coating.

10. Signal lamp according to Claim 6, characterized in that the light-transmitting casing of the diodes is cuboid or cylindrical.

11. Signal lamp according to Claim 1, characterized in that in the housing there are several orifices, each with an associated luminous diode, the luminous diodes are arranged on a common circuit board, and a common connection for the luminous diodes is located on the opposite side of the board.

## Revendications

1. Voyant lumineux comportant au moins une ouverture (1) réalisée dans un boîtier de voyant, chaque ouverture (1) laissant apparaître une diode lumineuse (10) et la diode lumineuse (10) est reliée à une plaque à circuit conducteur comportant les conducteurs de raccordement, parallèles à l'ouverture (1), voyant caractérisé en ce que la plaque à circuit conducteur (9) est fixée de manière amovible au boîtier de voyant (2, 3, 4), en ce que le boîtier de voyant (2, 3, 4) comporte un cadre frontal (2) entourant l'ouverture (1) et dont le contour périphérique est supérieur à celui de la plaque à circuit conducteur (9) et en ce que sur la face arrière du cadre frontal (2), il y a des nervures de centrage (4) orientées en direction de la plaque (9), nervures qui reçoivent la diode lumineuse (10) et en assurent le centrage dans l'ouverture (1).

2. Voyant lumineux selon la revendication 1, caractérisé en ce que la résistance (11) est associée à la diode lumineuse (10) par son axe longitudinal parallèle à celui de la plaque conductrice.

3. Voyant lumineux selon la revendication 1, caractérisé en ce que les bornes de raccordement (12) sont prévues sur la face de la plaque à circuit conducteur (9), opposée à la diode lumineuse (10).

4. Voyant lumineux selon la revendication 1, caractérisé par des moyens d'encliquetage (5) agissant latéralement.

5. Voyant lumineux selon la revendication 1, caractérisé en ce que la plaque à circuit conducteur (9) est reliée au boîtier du voyant par des moyens d'accrochage par encliquetage (8).

6. Voyant lumineux selon la revendication 1, caractérisé en ce que l'enveloppe transparente de la diode lumineuse (10) alignée axialement sur l'ouverture (1) recouvre celle-ci au moins approximativement.

7. Voyant lumineux selon l'une des revendications 1 à 6, caractérisé en ce que la plaque à circuit conducteur (9) est une plaque de circuits imprimés.

8. Voyant lumineux selon l'une des revendications 1 à 6, caractérisé en ce que la plaque à circuit conducteur (9) est une plaque en matière synthétique et comporte comme moyens de liaison des conducteurs ou des fils matricés dans celle-ci, et qui sont soudés ou brasés.

9. Voyant lumineux, selon l'une des revendications 1 à 6, caractérisé en ce que la plaque conductrice (9) est une plaque en matière synthétique qui comporte des chemins conducteurs imprimés ou réalisés sous forme d'un revêtement de métal.

10. Voyant lumineux selon la revendication 6, caractérisé en ce que l'enveloppe transparente des diodes est de forme carrée ou cylindrique.

11. Voyant lumineux selon la revendication 1, caractérisé en ce que le boîtier comporte plusieurs ouvertures auxquelles sont associées respectivement une diode lumineuse et en ce que les diodes lumineuses sont montées sur une plaque à chemin conducteur, commune, et un raccord commun pour les diodes lumineuses est prévu sur la face opposée de la plaque.

0 110 218

FIG.1

FIG.2

FIG.3

1